# EUROPEAN PATENT APPLICATION

(11) **EP 4 550 985 A1**
(43) Date of publication of application: **07.05.2025**
(21) Application number: 23207734.7
(22) Date of filing: 03.11.2023
(51) Int. Cl.: H10K 10/50, B82Y 10/00, H01H 1/00, H10K 85/00, B81B 5/00

(54) **BISTABLE SWITCH DEVICE AND OPTICALLY ACTIVE SURFACE DEVICE**

(71) Applicant: Technische Universität München, 80333 München (DE)
(72) Inventor: ROTHFISCHER, Florian, 81739 München (DE); KOPPERGER, Enzo, 80807 München (DE); LIST, Jonathan, 81925 München (DE); SIMMEL, Friedrich, 80336 München (DE)
(74) Representative: Hoefer & Partner Patentanwälte mbB

(57) **Abstract**

The invention concerns a bistable switch device (1), comprising: a base structure (2) spanning a common plane (3); a rod-shaped first (nano-)structure (4) and a rod-shaped second (nano-)structure (5), wherein the first (nano-)structure (4) and the second (nano-structure (5) are pivotably attached to the base structure (2), respectively, such as to be pivotable around a respective pivot point (6) lying in the common plane (3) or in a plane substantially parallel to the common plane; a connecting (nano-)structure (7) configured to connect an end (8) of the first (nano-)structure (4) with an end (10) of the second (nano-)structure (5); and a lever (nano-)structure (12) connected to and extending from an end (9) of the first (nano-)structure (4) opposite to the end (8) of the first (nano-)structure (4) that is connected with said end (10) of the second (nano-)structure (5). The invention also concerns an optically active surface device (100) comprising at least one bistable switch device (1).

## Description

The invention concerns a bistable switch device and an optically active surface device.

Conventionally, bistable switch devices are known from for example "Direct Design of an Energy Landscape with Bistable DNA Origami Mechanisms" by Zhou et al., Nano Letters 2015, 15, 1815 - 1821, DOI: 10.1021/nl5045633. Therein, a four-bar DNA mechanism is proposed which has two stable positions (also referred to as "bistable") separated by an energy barrier. Therein, a "snap-through" transition allows transition between the stable positions via a transverse load.

Such known solutions have the following disadvantages. Firstly, the proposed DNA mechanism does not allow for active switching between the two states. Instead, closing strands and releasing strands of single-stranded DNA ("ssDNA") are added to the mechanism for fixing the structure thereof. Thereby, a necessary time for switching is rather long (10 or more minutes). Secondly, the switching operation cannot be repeated often, as the strands which are added for the switching operations accumulate and sooner or later block subsequent switching operations. Therefore, the DNA mechanism proposed by Zhou et al. is not suitable for fast and active or specific control of repeated switching.

It is an object of the present invention to overcome the foregoing described disadvantages of the prior art. In particular, it is an object of the present invention to provide a bistable switch device that can be controlled actively and/or specifically and that allows fast switching, particularly with high repeatability. Further, it is an object of the present invention to provide an optically active surface device, preferably a display device, which provides the foregoing described advantages, particularly fast switching and low energy consumption as well as a high repeatability of switching.

The solution of this object is achieved by the features of the independent claim. The dependent claims contain advantageous embodiments of the present invention.

In particular, this object is achieved by a bistable switch device comprising a base structure spanning a common plane, a rod-shaped first (nano-)structure, a rod-shaped second (nano-)structure, a connecting (nano-)structure, and a lever (nano-)structure. Therein, the first (nano-)structure and the second (nano-)structure are pivotably attached to the base structure, respectively, such as to be pivotable around a respective pivot point lying in the common plane or in a plane substantially parallel to the common plane. The connecting (nano-)structure is configured to connect an end of the first (nano-)structure with an end of the second (nano-)structure. Further, the lever (nano-)structure is connected to and extends from the end of the first (nano-)structure opposite to the end of the first (nano-)structure that is connected with an end of the second (nano-)structure. In other words, for example, the lever (nano-)structure is connected to the first end of the first (nano-)structure, and the second end of the first (nano-)structure is connected to one end of the second (nano-)structure, the first and second ends of the first (nano-)structure being longitudinally opposite ends thereof.

Thereby, the bistable switch device of the present invention can be mechanically switched between steric bistable switching states of the first (nano-)structure and the second (nano-)structure via the lever (nano-)structure. Thus, a fast and repeatable switching operation is achieved.

Advantageously, the rod-shaped first (nano-)structure is a nanostructure.

Further advantageously, the rod-shaped second (nano-)structure is a nanostructure.

Further advantageously, the connecting (nano-)structure is a nanostructure.

Further advantageously, the lever (nano-)structure is a nanostructure. Preferably, the lever (nano-)structure is rod-shaped.

Preferably, the lever (nano-)structure is formed integrally or monolithically with the first (nano-)structure. Alternatively, the lever (nano-)structure is formed separately, i.e. not integrally or monolithically, from the first (nano-)structure and is attached thereto, for instance via a (further) connecting (nano-)structure.

In some preferable embodiments, the base structure is a nanostructure.

In the foregoing and in the following, "switching" and "states" refer to states of the device or its elements which are destruction-free. In particular, in the foregoing and in the following, destruction of any one or of all of the structures is not considered as a "stable state" or "uninhibited state" of the device. The switching between states is also destruction-free, especially repeatable.

Herein, unless certain dimensions are further specified, the term "nanosized" or "nanostructure" refers to the respectively referred element or object having a size in at least one of its dimensions (length, width, height) of at least one or a few to a few hundreds of nanometers (for example 10 nm to 500 nm), especially less than 1,000 nm (less than 1 µm). Preferably, not all dimensions of said element or object are necessarily "nanosized". For example, a length of one element or object may be equal to or larger than 1,000 nm, this element or object nonetheless being referred to as "nanosized" or "nanostructure" due to preferably a width and/or height thereof being only a few to a few tens or a few hundreds of nanometers. Most preferably, no more than one dimension (length, width, height) of the respective object or element referred to as "nanosized" or "nanostructure" is equal to or larger than 1,000 nm. In other words, preferably, at least two of its dimensions (length, width, height) are of at least one or a few to a few tens of nanometers (for example 10 nm to 50 nm), especially less than 1,000 nm (less than 1 µm).

Herein, the term "rod-shaped structure" preferably refers to an object with a length significantly larger than its width and/or height. For example, a length of such rod-like structure being a nanostructure may be a few tens of nanometers, for example between 20 nm and 40 nm, to a few hundreds of nanometers, for example between 300 nm and 500 nm, particularly 400 nm, whereas a width and a height thereof may be only a few nanometers, for example between 5 nm and 10 nm, respectively, thereby constituting a rod shape.

Further herein, the term "plate-shaped structure" preferably refers to an object, for example to the base structure, with a length and a width being significantly larger than its height. Herein, preferably, length and width thereof are not necessarily equal. For example, a length and a width of such plate-shaped structure being a nanostructure may be a few tens to a few hundreds of nanometers, for example between 30 nm and 70 nm, respectively, whereas a height thereof may be only a few nanometers, for example between 2 nm and 10 nm.

Preferably, the term "plate-shaped structure" refers to a flat plate-shaped structure, with at least one, especially all, surface(s) thereof being substantially flat.

In some preferable embodiments, a length of the rod-shaped first nanostructure and a length of the rod-shaped second nanostructure is substantially 30 nm, respectively. Preferably, especially in the case of the rod-shaped first nanostructure and the rod-shaped second nanostructure having a length of substantially 30 nm, a length of the lever nanostructure is substantially 400 nm. Preferably, a length and a width of the base structure, as a nanostructure, are substantially 55 nm, respectively, especially in combination with the foregoing described dimensions of the rod-shaped first nanostructure and/or of the rod-shaped second nanostructure and/or of the lever nanostructure.

Herein, the term "substantially" with respect to dimensions of elements or objects refers especially to manufacturing tolerances, particularly in the field of nanostructures. In some cases, "substantially" refers to tolerances of ±10 %.

In the following, merely in favor of better readability, the term "(nano-)" will be omitted. It is to be understood in the following as implied by the term "structure", unless otherwise specified. Furthermore, this also applies to the term "rod-shaped". Thus, the term "first structure" in the following implies "rod-shaped first (nano-)structure", with this reasoning applying mutatis mutandis to the other elements.

In some advantageous embodiments, the first structure and the second structure are arranged such that a collinear arrangement thereof is inhibited and/or unstable and such that two non-collinear arrangements thereof are uninhibited and/or stable. Therein, the lever structure is configured to provide mechanical advantage for switching between the two non-collinear arrangements. In other words, the lever structure may provide leverage for mechanically switching between the non-collinear arrangements, i.e. the two stable states. Together with the pivot point as a fulcrum, the lever exerts a torque on the first structure.

Preferably, the arrangement of the first structure and the second structure is such that the collinear, inhibited state is localized between the two non-collinear, uninhibited states. In other words, when switching between the two stable (uninhibited) states, the unstable (inhibited) state must be mechanically overcome/passed via the mechanical advantage of the lever structure. Thus, it is unlikely that the bistable switch device will be switched randomly (i.e. without active/specific operation) between the two stable (uninhibited) states.

In some preferable embodiments, a shortest distance between the pivot points of the first structure and the second structure is equal to or less than the sum of the lengths of the first structure and the second structure from their respective pivot point to the connecting structure. In other words, the shortest distance between the pivot points is equal to or less than the lengths of the first structure and the second structure from their respective pivot point to their connected ends. Thereby, the collinear arrangement of the first structure and the second structure is especially inhibited and mechanically/energetically disadvantageous.

Preferably, the connecting structure is configured to flexibly, especially elastically, connect the first structure with the second structure. In some examples, the connecting structure is formed integrally or monolithically with the first structure and the second structure, and comprises a higher flexibility and/or higher elasticity and/or lower rigidity than the first structure and the second structure, respectively. In other examples, the connecting structure is formed separately, i.e. not integrally and not monolithically, from the first structure and the second structure and is attached thereto.

In some preferable embodiments, the lever structure is configured to interact with an external force field, especially an electric and/or a magnetic field, such as to exert a torque on the first structure. Thereby, the mechanical action of the lever, i.e. leveraging for switching between the stable states via torque on the first structure, can be controlled via the external force field. The external force field can, in some examples, also be a (surrounding fluid) pressure field.

Preferably, the bistable switch device comprises or is in effective connection with one or more force field generators for generating an electric and/or magnetic field.

Preferably, the lever structure comprises electric charges and/or magnetic particles. In particular, the electric charges and/or the magnetic particles interact with said electric and/or magnetic field, respectively.

Preferably, the first structure, the second structure, and the lever structure respectively comprise electric charges, especially homogenously distributed electric charges. Thereby, in an electric field, due to the overall distribution of electric charges is different between the lever structure and the first structure on the one hand and the second structure on the other hand, the bistable switch device can be switched with an electric field.

Preferably, the lever structure comprises at least one magnetic particle such that the lever structure comprises or consists of a magnetic dipole. In other words, the ends of the lever structure form a magnetic dipole. Thereby, in a magnetic field, the field exerts a torque, via the lever structure, on the first structure and may switch the bistable switch device between the non-collinear arrangements by overcoming/passing the collinear arrangement.

Preferably, an energy level of the two non-collinear arrangements is lower than k_{b}T, respectively, and a difference between the energy level of the collinear arrangement and the energy level of the two non-collinear arrangements is higher than k_{b}T, k_{b} being the Boltzmann constant and T being the temperature of the bistable switch device. Preferably, the energy levels are defined with respect to the temperature T being between 20 and 30 °C, preferably ISO 1 standard reference temperature of 20° C or 293.15 Kelvin. Thereby, the collinear arrangement, the energy level difference thereof to the non-collinear arrangements being higher than k_{b}T, prevents a switching between the non-collinear arrangements solely by Brownian motion energy. In other words, switching does not occur "accidentally"/arbitrarily, but only actively, i.e. following an operation of the lever structure.

Preferably, the difference between the energy level of the collinear arrangement and the energy level of the two non-collinear arrangements is 8 to 20 times k_{b}T, more preferably 8 to 15 times k_{b}T, and most preferably 8 to 9 times k_{b}T.

In some advantageous embodiments, the first structure, the second structure, the connecting structure, and the lever structure each comprise or consist of a nucleic acid structure and/or a protein. In other words, the structures preferably comprise or consist of an organic molecule, respectively.

Preferably, the nucleic acid structure is DNA or RNA. Preferably, these may be in the single-stranded or double-stranded form.

Preferably, the first structure, the second structure, and the lever structure each comprise or consist of double-stranded DNA and the connecting structure comprises or consists of single-stranded DNA. For example, in the preferable case of the connecting structure being formed monolithically with the first structure and the second structure, the first structure and the second structure are formed of double-stranded DNA, and the connecting structure is formed of single-stranded DNA being one of the two strands of the double-stranded DNA of the first structure and the second structure.

Preferably, the first structure and the second structure are attached, at their pivot points, to the base structure via single-stranded DNA, respectively.

Preferably, the base structure is a plate-shaped structure.

In some preferable embodiments, the bistable switch device comprises a plurality of any one or more of base structures, first structures, second structures, connecting structures and lever structures.

Preferably, a number of base structures and a number of first structures or of second structures are equal.

In other embodiments, the bistable switch device comprises one base structure and a plurality of first structures and a plurality of second structures attached to said one base structure, respectively.

For example, a plurality of base structures are provided, each with one first structure, one second structure, one connecting structure, and one lever structure. In other examples, one base structure is provided, on which multiple first structures, second structures and corresponding connecting and lever structures are provided. In other words, multiple switches may be provided, each on their own base structure, or all on one common base structure, the multiple switches sharing the common base structure.

In some advantageous embodiments, the first structure and/or the second structure and/or the lever structure comprise(s) at least one marker. Preferably, the marker is a fluorescence marker. In other examples, the marker is a nanoparticle for detection of surface plasmons (surface plasmon resonance, SPR, or surface plasmon enhanced light scattering, SP-LS), for example a gold or silver nanoparticle. Thereby, the switching state can be detected or verified via fluorescence microscopy or surface plasmon resonance microscopy, respectively. Preferably, for high sensitivity to SPR, the nanoparticle is arranged at/attached to a distal end of the lever structure (i.e. at/to the end of the lever structure opposite to its end being connected to the first structure).

Further, the present invention concerns an optically active surface device comprising at least one bistable switch device according to any one of the embodiments described above and a force field generating device for generating a force field configured to selectively switch the bistable switch device between the two non-collinear arrangements. Preferably, the force field is a controllable electric field and/or magnetic field.

Preferably, the optically active surface device is a display device such as a so-called "E-ink device" or "E-ink tablet" comprising a (high) plurality of bistable switch devices, preferably on the order of thousands to tens of thousands of bistable switch devices per pixel. In one illustrative example, roughly four bistable switch devices may be provided per µm² of display area of such an optically active surface device. With a high resolution display having an exemplary pixel size of around 2500 µm², each pixel of such an example may contain roughly 10,000 bistable switch devices, which are especially switched synchronously.

Further details, advantages, and features of the preferred embodiments of the present invention are described in detail with reference to the figures. Therein:
Fig. 1 shows a schematic drawing of aspects of a bistable switch device according to a first embodiment of the present invention in a first switched state;
Fig. 2 shows a schematic drawing of aspects of the bistable switch device according to the first embodiment of the present invention in a second switched state;
Fig. 3 shows a schematic drawing of the bistable switch device according to the first embodiment of the present invention; and
Fig. 4 shows a schematic drawing of an optically active surface device according to an embodiment of the present invention.

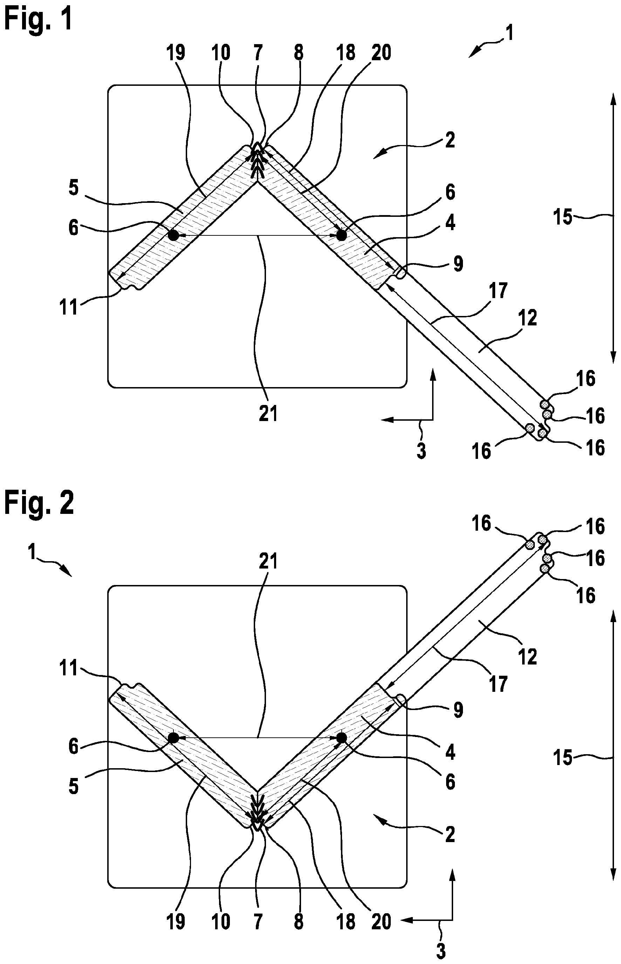

A first embodiment of a bistable switch device 1 will be explained with reference to Figs. 1 and 2. Therein, Fig. 1 shows a schematic drawing of aspects of a bistable switch device 1 according to the first embodiment of the present invention in a first switched state, and Fig. 2 shows a schematic drawing of aspects of the bistable switch device 1 according to the first embodiment of the present invention in a second switched state.

The bistable switch device 1 comprises a base structure 2 spanning a common plane 3, a rod-shaped first (nano-)structure 4, a rod-shaped second (nano-)structure 5, a connecting (nano-)structure 7, and a lever (nano-)structure 12. In the present embodiment, the base structure 2 is a plate-shaped nanostructure, the first structure 4 is a rod-shaped nanostructure, the second structure 5 is a rod-shaped nanostructure, the connecting structure 7 is a nanostructure, and the lever structure 12 is a rod-shaped nanostructure.

For example, dimensions (length and width) of the plate-shaped base structure 2 are substantially 55 nm x 55 nm. A length 17 of the lever structure 12 is substantially 400 nm. Lengths 18, 19 of the first structure 4 and of the second structure 5 are substantially 30 nm, respectively.

In the following, for ease of explanation, the term "(nano-)structure" or "nanostructure" is abbreviated as "structure".

Herein, the first structure 4, the second structure 5, the connecting structure 7, and the lever structure 12 each consist of a nucleic acid structure.

Herein, the first structure 4, the second structure 5, and the lever structure 12 each comprise or consist of double-stranded DNA and the connecting structure 7 comprises or consists of single-stranded DNA. In this example, the connecting structure 7 comprises a plurality of single-stranded DNA, for example five strands of single-stranded DNA. The lever structure 12 is preferably formed monolithically with the first structure 4. In other examples, the lever structure 12 is formed separately, i.e. not integrally and not monolithically, from the first structure 4 and attached thereto, for example via a (further) connecting structure (not shown).

As shown herein, the lever structure 12 and the first structure 4 are collinear. However, in other examples, the lever structure 12 can be attached to or formed integrally/monolithically with the first structure 4 enclosing an angle unequal to 180°, i.e. non-collinearly.

Herein, as a comparison of Fig. 1 with Fig. 2 shows, the first structure 4 and the second structure 5 are pivotably attached to the base structure 2, respectively, such as to be pivotable around a respective pivot point 6 lying in the common plane 3.. Further, the first structure 4 and the second structure 5 are attached, at their respective pivot points 6, to the base structure 2 via single-stranded DNA.

The connecting structure 7 connects a first end 8 of the first structure 4 with a first end 10 of the second structure 5. Further, the lever structure 12 is connected to and extends from a second end 9 of the first structure 4 opposite to the first end 8 of the first structure 4 that is connected with the first end 10 of the second structure 5.

Now, a configuration of the bistable switch device 1 for switching will be explained.

The first structure 4 and the second structure 5 are arranged such that a collinear arrangement thereof is inhibited and/or unstable and such that two non-collinear arrangements thereof are uninhibited and/or stable. The two non-collinear arrangements, also referred to as "first switched state" and "second switched state" are shown in Figs. 1 and 2, respectively.

Therein, the lever structure 12 provides, as a lever, mechanical advantage for switching between the two non-collinear arrangements. In other words, the lever structure 12 provides leverage for mechanically switching between the two non-collinear arrangements, i.e. the two stable states. Together with the pivot point 6 as a fulcrum, the lever structure 12 exerts a torque on the first structure 12 for overcoming/passing the unstable collinear arrangement.

Herein, the collinear, inhibited state is localized between the two non-collinear, uninhibited states. In other words, when switching between the two stable states, the inhibited state must be mechanically overcome/passed via the mechanical advantage of the lever structure 12. Thus, it is unlikely that the bistable switch device 1 will be switched randomly between the two uninhibited states .

A shortest distance 21 between the respective pivot points 6 of the first structure 4 and the second structure 5 is equal to or less than the sum of the lengths 19, 20 of the first structure 4 and the second structure 5 from their respective pivot point 6 to the connecting structure 7. In other words, the shortest distance 21 between the respective pivot points 6 is equal to or less than the lengths 19, 20 of the first structure 4 and the second structure 5 from their respective pivot point 6 to their connected first ends 8, 10, respectively. Thereby, the collinear arrangement of the first structure 4 and the second structure 5 is especially inhibited and mechanically/energetically disadvantageous.

Herein, an energy level of the two non-collinear arrangements is lower than k_{b}T, respectively, and a difference between the energy level of the collinear arrangement and the energy level of the two non-collinear arrangements is higher than k_{b}T, k_{b} being the Boltzmann constant and T being the temperature of the bistable switch device. Preferably, the energy levels are defined with respect to the temperature T being between 20 - 30 °C, preferably ISO 1 standard reference temperature of 20° C or 293.15 Kelvin. Thereby, the collinear arrangement, the difference in energy level thereof to the two non-collinear arrangements being higher than k_{b}T, prevents a switching between the non-collinear arrangements solely by Brownian motion energy. In other words, switching does not occur "accidentally" or arbitrarily, but only actively via the lever structure 12.

In this specific example, the energy level difference between the collinear arrangement and the two non-collinear arrangements is 8 to 20 times k_{b}T at standard reference temperature.

The connecting structure 7 is configured to flexibly, especially elastically, connect the first structure 4 with the second structure 5. Further, the first structure 4 and the second structure 5 are connected to the base structure 2 at their pivot points 6 via single-stranded DNA, respectively. Therefore, although energetically disadvantageous, these connections are flexible and thus allow for switching between the two non-collinear states by overcoming/passing the energetically disadvantageous collinear arrangement.

For switching between the two stable states, the lever structure 12 is configured to interact with an external force field 15, especially an electric and/or a magnetic field, such as to exert a torque on the first structure 4. Thereby, the mechanical action of the lever structure 12, i.e. leveraging for switching between said two states via torque on the first structure 4, can be controlled via the external force field 15.

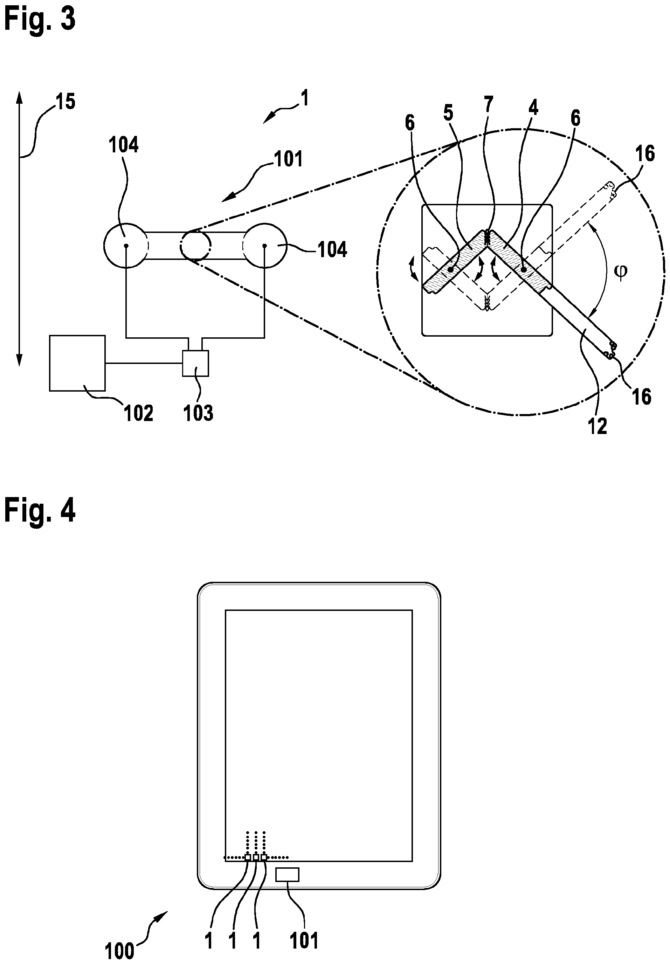

This will be explained in view of Fig. 3. Therein, a schematic drawing of the bistable switch device 1 according to the first embodiment of the present invention is shown.

In particular, Fig. 3 depicts a force field generator 101 for generating an electric field (henceforth "electric field generator 101"). The area zoomed out of Fig. 3 shows a combined view of Figs. 1 and 2. As can be taken therefrom, the two non-collinear states define an angle φ (i.e. the angle enclosed by the lever structure 12 when the bistable switch device is in the first and second stable state), which in the present embodiment is substantially 90°.

As can be taken from Fig. 3, the electric field generator 101 comprises two insulated electrodes 104 which are connected to an op amp 103. The op amp 103 is connected to a controller 102. Herein, a voltage of ±200 V is applied to the electrodes 104 for switching between the two stable states.

The lever structure 12 as well as the first structure 4 and the second structure 5 respectively comprise homogenously distributed electric charges, particularly on the surface of the DNA they comprise or they consist of. In the present embodiment, these electric charges cause an overall uneven charge distribution or number of charges between the combination of the lever structure 12 and the first structure 4 versus the second structure 5. Thereby, the force or torque generated in the lever structure 12 and the first structure 4 is greater than the force or torque generated in the second structure 5 such that the bistable switch device 1 can be switched via application of the electric field using the electrodes 104.

Thereby, the bistable switch device 1 provides fast actively controlled switching. Furthermore, the switching operations show high repeatability.

Thereby, the generated field 15 exerts a torque, via the electric charges of the lever structure 12, on the first structure 4 and switches between the two non-collinear arrangements by overcoming/passing the collinear arrangement.

Furthermore, the lever structure 12 comprises at least one marker 16. Preferably, the marker 16 is a fluorescence marker. In other examples, the marker 16 is a nanoparticle for detection of surface plasmons (SPR and/or SP-LS), for example a gold or silver nanoparticle. Thereby, the switching state can be detected or verified via fluorescence microscopy or surface plasmon resonance microscopy, respectively.

The present invention also concerns an optically active surface device 100, as shown in Fig. 4. Therein, a schematic drawing of the optically active surface device 100 according to an embodiment of the present invention is shown.

The optically active surface device 100 is a display device, for example an "E-ink tablet". The display device 100 comprises a plurality of bistable switch devices 1 according to one of the foregoing embodiments. Further, the display device 100 comprises a force field generating device 101, for example one or more of the force field generating device(s) 101 (electric field generating device 101) of Fig. 3, for generating a force field 15 configured to selectively switch the bistable switch devices 1 between the two non-collinear arrangements, respectively. Said two states may correspond to "white" and "black" or for instance to "transparent" and "opaque" with respect to a backlight (not shown).

In one illustrative example, roughly four bistable switch devices 1 may be provided per µm² of display area of such an optically active surface device 100. With a high resolution display having an exemplary pixel size of around 2,500 µm², each pixel may contain roughly 10,000 bistable switch devices 1, which are especially switched synchronously.

The display device 100 preferably also comprises a large number of electrodes 104, for example those shown in Fig. 3 corresponding to the number of bistable switch devices 1 and for controlling switching of each pixel.

Thereby, the display device 100 can be switched fast between displayed pictures or texts. Due to the switched states of the switch devices 1 being stable, energy input is preferably only necessary when switching, as opposed to being input continuously. Thereby, energy consumption is reduced.

In addition to the foregoing written explanations, it is explicitly referred to the figures, which in detail show configuration examples and technical details of the invention.

### Reference Numerals

- 1: bistable switch device
- 2: base structure
- 3: common plane
- 4: first (nano-)structure
- 5: second (nano-)structure
- 6: pivot point
- 7: connecting (nano-)structure
- 8: first end of first (nano-)structure
- 9: second end of first (nano-)structure
- 10: first end of second (nano-)structure
- 11: second end of second (nano-)structure
- 12: lever (nano-)structure
- 15: external force field
- 16: marker
- 17: length of lever (nano-)structure
- 18: length of first (nano-)structure
- 19: length of second (nano-)structure
- 20: length of first/second (nano-)structure from pivot point to connecting (nano-)structure
- 21: shortest distance between pivot points
- 100: optically active surface device / display device
- 101: force field generating device
- 102: controller
- 103: op amp
- 104: electrode

## Claims

1. Bistable switch device (1), comprising:
a base structure (2) spanning a common plane (3);
a rod-shaped first (nano-)structure (4) and a rod-shaped second (nano-)structure (5), wherein the first (nano-)structure (4) and the second (nano-)structure (5) are pivotably attached to the base structure (2), respectively, such as to be pivotable around a respective pivot point (6) lying in the common plane (3) or in a plane substantially parallel to the common plane;
a connecting (nano-)structure (7) configured to connect an end (8) of the first (nano-structure (4) with an end (10) of the second (nano-)structure (5); and
a lever (nano-)structure (12) connected to and extending from an end (9) of the first (nano-)structure (4) opposite to the end (8) of the first (nano-)structure (4) that is connected with said end (10) of the second (nano-)structure (5).

2. Bistable switch device (1) according to claim 1, wherein the first (nano-)structure (4) and the second (nano-)structure (5) are arranged such that a collinear arrangement thereof is inhibited and/or unstable and such that two non-collinear arrangements thereof are uninhibited and/or stable, and wherein the lever (nano-)structure (12) is configured to provide mechanical advantage for switching between the two non-collinear arrangements.

3. Bistable switch device (1) according to any one of the foregoing claims, wherein a shortest distance (21) between the pivot points (6) of the first (nano-)structure (4) and the second (nano-)structure (5) is equal to or less than the sum of the lengths (20) of the first (nano-)structure (4) and the second (nano-)structure (5) from their respective pivot point (6) to the connecting structure (7).

4. Bistable switch device (1) according to any one of the foregoing claims, wherein the connecting (nano-)structure (7) is configured to flexibly, especially elastically, connect the first (nano-)structure (4) with the second (nano-)structure (5).

5. Bistable switch device (1) according to any one of the foregoing claims, wherein the lever (nano-)structure (12) is configured to interact with an external force field (15), especially an electric and/or a magnetic field, such as to exert a torque on the first (nano-)structure (4).

6. Bistable switch device (1) according to claim 5, wherein the lever (nano-)structure (12) comprises electric charges and/or magnetic particles.

7. Bistable switch device (1) according to any one of claims 2 to 6, wherein an energy level of the two non-collinear arrangements is lower than k_{b}T, respectively, and wherein a difference between the energy level of the collinear arrangement and the energy level of the two non-collinear arrangements is higher than k_{b}T, k_{b} being the Boltzmann constant and T being the temperature of the bistable switch device (1).

8. Bistable switch device (1) according to any one of the foregoing claims, wherein the first (nano-)structure (4), the second (nano-)structure (5), the connecting (nano-)structure (7), and the lever (nano-)structure (12) each comprise or consist of a nucleic acid structure and/or a protein.

9. Bistable switch device (1) according to claim 8, wherein the nucleic acid structure is DNA or RNA.

10. Bistable switch device (1) according to claim 9, wherein the first (nano-)structure (4), the second (nano-)structure (5), and the lever (nano-)structure (12) each comprise or consist of double-stranded DNA and wherein the connecting (nano-)structure (7) comprises or consists of single-stranded DNA.

11. Bistable switch device (1) according to any one of the foregoing claims, wherein the first (nano-)structure (4) and the lever (nano-)structure (12) are formed integrally or monolithically.

12. Bistable switch device (1) according to any one of the foregoing claims, wherein the base structure (2) is a plate-shaped structure.

13. Bistable switch device (1) according to any one of the foregoing claims, wherein a number of base structures (2) and a number of first (nano-)structures (4) or of second (nano-structures (5) are equal or wherein the bistable switch device (1) comprises one base structure (2) and a plurality of first (nano-)structures (4) and a plurality of second (nano-)structures (5) attached to said one base structure (2), respectively.

14. Bistable switch device (1) according to any one of the foregoing claims, wherein the first (nano-)structure (4) and/or the second (nano-)structure (5) and/or the lever (nano-)structure (12) comprise(s) at least one marker (16), preferably a fluorescence marker or a nanoparticle for detection of surface plasmons.

15. Optically active surface device (100), preferably a display device, comprising at least one bistable switch device (1) according to any one of the foregoing claims and a force field generating device (101) for generating a force field configured to selectively switch the bistable switch device (1) between the two non-collinear arrangements.
